(19) Europäisches Patentamt
European Patent Office
Office européen des brevets

(11) Veröffentlichungsnummer: **0 257 292**
**A1**

(12) # EUROPÄISCHE PATENTANMELDUNG

(21) Anmeldenummer: **87110449.3**

(22) Anmeldetag: **18.07.87**

(51) Int. Cl.⁴: **G01S 17/10**, H03K 5/153, G04F 10/00

(30) Priorität: **13.08.86 CH 3240/86**

(43) Veröffentlichungstag der Anmeldung: **02.03.88 Patentblatt 88/09**

(84) Benannte Vertragsstaaten: **AT BE DE ES FR GB IT NL SE**

(71) Anmelder: **ZELLWEGER USTER AG**
**Wilstrasse 11**
**CH-8610 Uster(CH)**

(72) Erfinder: **Mira, Silvio**
**Leubergstrasse 45**
**CH-8615 Wermatswil(CH)**
Erfinder: **Schwarte, Rudolf, Prof. Dr.**
**Kreutztaler Strasse 56**
**D-5902 Netphen-Dreistiefenbach(DE)**

(54) **Optoelektrisches Entfernungsmessgerät nach dem Prinzip der Laufzeitmessung.**

(57) Das Gerät enthält einen Pulsdetektor (8) zur Bildung der Differenz aus dem einem von einem angemessenen Zielobjekt reflektierten Lichtimpuls entsprechenden elektrischen Puls und einer verzögerten, invertierten Kopie davon zum Zweck der Gewinnung eines für den Empfang des reflektierten Lichtimpulses signifikanten Signals. Die Verzögerung und Inversion des Pulses erfolgt durch eine ein kurzgeschlossenes Ende (l6) aufweisende Laufzeitleitung (l7), im Abstand (L) von deren kurzgeschlossenem Ende (l6) ein Schwellwert-und Nulldurchgangsdetektor (l2) angeordnet ist.

Die Verwendung der Laufzeitleitung (l7) gestaltet den Aufbau des Pulsdetektors (8) äusserst einfach und ermöglicht eine sichere, genaue und ungestörte Detektion des reflektierten Lichtimpulses.

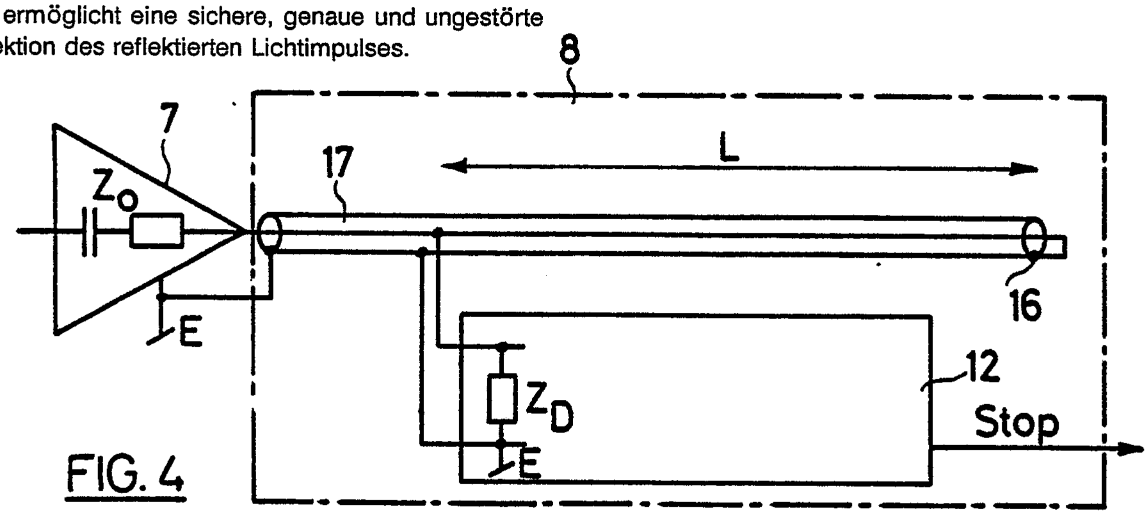


FIG. 4

EP 0 257 292 A1

# Optoelektrisches Entfernungsmessgerät nach dem Prinzip der Laufzeitmessung

Die Erfindung betrifft ein optoelektrisches Entfernungsmessgerät nach dem Prinzip der Laufzeitmessung, mit einem eine Laserdiode enthaltenden Sender, mit einem eine Photodiode aufweisenden Empfänger zum Empfang der von einem Zielobjekt reflektierten Lichtimpulse, mit einem Pulsverstärker, mit einem Pulsdetektor zur Bildung der Differenz aus dem einem reflektierten Lichtimpuls entsprechenden Originalpuls und einer verzögerten Kopie davon zum Zweck der Abgabe eines für den Zeitpunkt des Empfangs eines reflektierten Lichtimpulses signifikanten Stopsignals, und mit einer Zeitmessschaltung zur Ermittlung der Zeit zwischen dem Start des ausgesandten Lichtimpulses und dem Stopsignal des Pulsdetektors.

Bei kurzen Impulsen besteht das Problem, dass diese nicht formgetreu verstärkt werden können, so dass das zeitsignifikante Signal nur aus der auch nach der Verstärkung originalgetreuen Anstiegsflanke gewonnen werden muss. Ein dafür geeignetes Verfahren ist in der Dissertation von A. Glasmachers "Elektronische Schaltungen für die Kernstrahlungsmesstechnik im Weltraum dargestellt am Zeitmesskanal eines Massenspektrometers", Bochum l978, beschrieben. Bei diesem Verfahren mit einem sogenannten "Constant Fraction Trigger" wird das verzögerte Signal mit dem Faktor -2 multipliziert und es wird der Nulldurchgang der Summe aus dem Originalsignal und dem verzögerten Signal detektiert. Dieser Nulldurchgang der Summe tritt dann auf, wenn die Anstiegsflanke einen konstanten Bruchteil der Pulsamplitude erreicht hat und ist somit unabhängig von der absoluten Grösse der Amplitude.

Bei der verwendeten Schaltung finden sowohl am leerlaufenden Anfang als auch am kurzgeschlossenen Ende der Laufzeitleitung Reflexionen statt. Ein einmal in die Laufzeitleitung eingebrachter Impuls wird darin mehrmals hinund herpendeln, bis er von den Verlusten ganz absorbiert ist; dies hat zur Folge, dass verfrühte Lichtreflexionen, die zum Beispiel von der Optik oder von Rückstreuungen in der Luft herrühren, die Detektion des Nutzpulses verfälschen können.

Bei einem aus der DE-OS 26 34 627 bekannten Laserentfernungsmessgerät nach dem Prinzip der Laufzeitmessung ist in der Diodenempfangsschaltung als Arbeitswiderstand ein Parallelresonanzkreis geschaltet, der vom reflektierten Lichtimpuls über die Empfangsdiode definiert angestossen wird und entsprechend seiner Eigenresonanz anschwingt. Das Stopsignal wird anhand der intensitätsunabhängigen Nulldurchgänge des angestossenen Sinussignals gewonnen.

Auch bei diesem Entfernungsmessgerät kann die Detektion des Nutzimpulses durch nicht vom Zielobjekt herrührende verfrühte Lichtreflexionen verfälscht werden und ausserdem ist der Empfänger verglichen mit demjenigen von Glasmachers weniger rauscharm und empfindlich.

Durch die Erfindung soll nun ein Entfernungsmessgerät der eingangs beschriebenen Gattung angegeben werden, dessen Empfänger rauscharm und sehr empfindlich ist und bei dem keine Störungen durch verfrühte Lichtimpulse auftreten können.

Diese Aufgabe wird erfindungsgemäss dadurch gelöst, dass ein Pulsverstärker mit reflexfrei angepasster Ausgangsimpedanz eine Laufzeitleitung treibt, an deren kurzgeschlossenem Ende eine Inversion und Reflexion des Pulses des Pulsverstärkers stattfindet, und dass in einem der Dauer des auszuwertenden Pulses angepassten Abstand vom kurzgeschlossenen Ende der Laufzeitleitung ein Schwellwert-und Nulldurchgangsdetektor angeordnet ist.

Beim erfindungsgemässen Entfernungsmessgerät wird das zeitsignifikante Signal nicht nur aus der Anstiegsflanke, sondern aus Vorder-und Rückflanke des Pulses gewonnen. Die Laufzeitleitung alleine übernimmt die Aufgabe der Verzögerung, Inversion und Addition des Pulses und sie begrenzt die Frequenzbandbreite nach unten - nach oben erfolgt die Begrenzung durch den Pulsverstärker - was sich günstig auf das Rauschverhalten auswirkt. Da der Puls die Laufzeitleitung hin und zurück durchläuft und anschliessend verschwindet, können verfrühte Lichtreflexionen die Detektion des Nutzpulses nicht verfälschen. Ausserdem kann der Empfänger grundsätzlich beliebige Pulsamplituden verarbeiten, da keine nichtlinearen oder gar begrenzenden Schaltungselemente beteiligt sind.

Schliesslich sei noch erwähnt, dass bei bekannten Geräten als Kriterium für den Start des ausgesandten Lichtimpulses das Startsignal des geräteinternen Taktgebers an die Laserdiode verwendet wird. Man kann auch das erfindungsgemässe Entfernungsmessgerät auf diese Weise betreiben, man kann aber auch, wegen dessen Unanfälligkeit gegen verfrühte Lichtreflexionen, einen Teil des ausgesandten Lichtimpulses durch den Empfangskanal leiten und als Startsignal verwenden, was eine erhöhte Messgenauigkeit ermöglicht.

Nachstehend wird die Erfindung anhand eines Ausführungsbeispiels und der Zeichnungen näher erläutert; es zeigen:

Fig. l ein Blockschema eines erfindungsgemässen Entfernungsmessgeräts,

Fig. 2 ein Diagramm zur Funktionserläuterung,

Fig. 3 ein Schema zur Funktionserläuterung,

Fig. 4, 5 je ein Detail von Fig. I,

Fig. 6 ein Diagramm zur Funktionserläuterung, und

Fig. 7 eine leicht vereinfachte Darstellung der Schaltung eines Details des Entfernungsmessgeräts von Fig. I.

Das in Fig. I dargestellte Entfernungsmessgerät arbeitet nach dem Prinzip der Pulslaufzeitmessung und dient zur Ermittlung der Entfernung d eines Zielobjektes A. Es enthält im wesentlichen einen Taktgeber I, einen Sender 2 mit einer Laserdiode (nicht dargestellt) und einer Sendeoptik 3, einen Empfänger 4 mit einer Empfangsoptik 5, einer Photodiode 6 und einem Pulsverstärker 7, einen Pulsdetektor 8 und eine Zeitmessschaltung 9. Entfernungsmessgeräte dieser Art sind grundsätzlich bekannt. Es wird in diesem Zusammenhang auf die in der Beschreibungseinleitung zitierten Literaturstellen sowie auf die Internationale Anmeldung PCT/EP85/00236 (Veröffentlichungsnummer WO 85/05456) mitsamt dem in dieser zitierten Stand der Technik verwiesen.

Der Sender 2 erzeugt, getriggert von einem Startsignal des Taktgebers I, einen kurzen Lichtimpuls mit einer Dauer von etwa I5 ns, der über die Sendeoptik 3 zum Zielobjekt A gelangt und von diesem reflektiert oder rückgestreut wird. Ein kleiner Teil des reflektierten Lichtimpulses wird durch die Empfangsoptik 5 auf die Photodiode 6 fokussiert und erzeugt in dieser einen Stromimpuls, welcher vom Pulsverstärker 7 in einen proportionalen Spannungsimpuls U umgewandelt wird. Aus diesem Spannungsimpuls U gewinnt der Pulsdetektor 8 ein Stopsignal, welches der Zeitmessschaltung 9 zugeführt wird. Die Zeitmessschaltung 9 misst und digitalisiert die Zeitspanne zwischen diesem Stopsignal und dem vom Taktgeber I erhaltenen Startsignal und liefert einen Messwert M für die Pulslaufzeit $t_L$ vom Sender 2 zum Zielobjekt A und von diesem zurück zum Empfänger 4. Wenn d die Entfernung zwischen Entfernungsmessgerät und Zielobjekt A und c die Lichtgeschwindigkeit bezeichnet, dann gilt für die Pulslaufzeit $t_L$ die folgende Gleichung:

$$t_L = \frac{2d}{c}$$

Ein wesentliches Element des Entfernungsmessgeräts bildet der Pulsdetektor 8, welcher das Eintreffen eines auswertbaren Spannungspulses U feststellt und ein für den Zeitpunkt seines Eintreffens signifikantes, von der Pulsamplitude unabhängiges elektrisches Signal, das schon erwähnte Stopsignal, abgibt.

Die Funktionsweise des Pulsdetektors 8 ist aus dem in Fig. 2 dargestellten Diagramm ersichtlich. In diesem ist mit t die Zeitachse, mit U der Originalpuls (Ausgangssignal des Pulsverstärkers 7), mit $U_K$ eine verzögerte und invertierte Kopie des Originalpulses U, mit D die Differenz $U_K$ -U, mit N der Nulldurchgang von D, mit T die Verzögerung von $U_K$ gegenüber U und mit $U_T$ein Schwellwert bezeichnet. Wenn der Betrag der Differenz D den Schwellwert $U_T$ überschreitet, dann wird das Signal als auswertbar taxiert.

Der Nulldurchgang N liefert das für den Zeitpunkt des Auftretens des Spannungspulses U und damit des Eintreffens eines reflektierten Lichtimpulses im Empfänger 4 (Fig. I) signifikante Signal. Dies ist deswegen möglich, weil bei gleichbleibender Form des Originalpulses bezüglich dessen Anstiegszeit, Breite und Abfallzeit der zeitsignifikante Nulldurchgang N von der Amplitude des Pulses unabhängig ist.

Wie Fig. 3 entnommen werden kann, enthält der Pulsdetektor 8 in seinem prinzipiellen Aufbau eine vom Pulsverstärker 7 (Fig. I) kommende Leitung I0, welche einerseits über ein Additionsglied II an einen Schwellwert-und Nulldurchgangsdetektor I2 geführt ist, und von welcher anderseits ein Ast I3 abzweigt, welche ein Verzögerungsglied I4 und ein Inversionsglied I5 enthält und ebenfalls an das Additionsglied II geführt ist, an dessen Ausgang die Differenz D (Fig. 2) erhältlich ist.

Verzögerung und Inversion eines Pulses lassen sich besonders einfach mit einer kurzgeschlossenen Laufzeitleitung bewerkstelligen, wie dies in Fig. 4 dargestellt ist: Der Pulsverstärker 7 (Fig. I) mit der Ausgangsimpedanz $Z_o$treibt eine an ihrem anderen Ende einen Kurzschluss I6 aufweisende Laufzeitleitung I7, deren charakteristische Grössen die Fortpflanzungsgeschwindigkeit und die Wellenimpedanz sind. Die Ausgangsimpedanz $Z_o$ des Pulsver stärkers 7 ist reflexfrei an die Wellenimpedanz der Laufzeitleitung I7 angepasst. Der Spannungspuls wandert durch die Laufzeitleitung I7 zum Kurzschluss I6, wird dort invertiert, wandert zurück und wird vom Pulsverstärker 7 absorbiert.

Im Abstand L vor dem Kurzschluss I6 ist an die Laufzeitleitung I7 der Schwellwert-und Nulldurchgangsdetektor I2 angeschlossen, dessen Eingangsimpedanz $Z_D$ so hoch gewählt ist, dass sie die Vorgänge auf der Laufzeitleitung I7 nicht beeinflusst. Der Schwellwert-und Nulldurchgangsdetektor I2 "sieht" die in Fig. 2 dargestellte Superposition mit der Verzögerungszeit T, wobei gilt:

$$T = 2 \frac{L}{v} \text{ (v-Fortpflanzungsgeschwindigkeit)}$$

L ist dabei so gewählt, dass T etwa der halben Pulsbreite entspricht, was einen optimal steilen Nulldurchgang von D (Fig. 2) ergibt. Die Erdpunkte der Schaltung sind mit E bezeichnet.

Für die Ausbildung der Laufzeitleitung I7 sind mehrere Varianten möglich, man kann sie beispielsweise auch - mit geeigneter Wellenimpedanz - als eine an ihrem Ende kurzgeschlossene Abzweigung an die Verbindungsleitung zwischen Pulsverstärker 7 und Schwellwert-und Nulldurchgangsdetektor I2 anschliessen, oder man kann anstelle einer echten Leitung eine Nachbildung aus mehreren elektrischen Verzögerungsgliedern einsetzen.

In Fig. 5 ist das Schaltungsprinzip des Schwellwert-und Nulldurchgangsdetektors I2 dargestellt, welcher darstellungsgemäss durch einen Schmitt-Trigger gebildet ist, dessen Komparator I8 symmetrische Gegentakt-Ausgänge OUT und $\overline{OUT}$ aufweist. Durch ein RC-Netzwerk $R_1$, $C_1$; $R_2$, $C_2$ ist der Gleichspannungsruhepegel am Komparatoreingang IN gleich dem Ruhepegel am Ausgang OUT.

Die Schaltvorgänge des den Schwellwert-und Nulldurchgangsdetektor I2 bildenden Schmitt-Triggers sind in Fig. 6 dargestellt: Zeile a zeigt dessen Eingangssignal D, Zeile b zeigt das Signal $U_{\overline{OUT}}$ am Ausgang $\overline{OUT}$ und Zeile c zeigt das Signal $U_{OUT}$ am Ausgang OUT, wobei diese beiden Spannungen jeweils entweder den Wert $U_{OL}$ oder $U_{OH}$ aufweisen.

Im Ruhezustand ist:

$$U_{OUT}\,(AUS) = U_{OH} = U_{IN}\,(Ruhe)$$

und

$$U_{\overline{OUT}}\,(AUS) = U_{OL} = U_{ref}\,(AUS)$$

Wenn das Eingangssignal D, das auf dem Ruhepegel $U_{IN}$(Ruhe) "reitet", die Schwellspannung $U_T = U_{ref}\,(AUS) - U_{IN}\,(Ruhe) = U_{OL} - U_{OH}$ unterschreitet, dann schaltet der Komparator I8 EIN. Da beide Komparatorausgänge gleichartig gebaut sind, wird jetzt

$$U_{\overline{OUT}}\,(EIN) = U_{OH} = U_{OUT}\,(AUS)$$

und somit

$$U_{ref}\,(EIN) = U_{IN}\,(Ruhe)$$

Der Gleichspannungspegel von $U_{IN}$ ändert sich nicht.

Genau dann, wenn $U_{IN}$ seinen Ruhepegel wieder kreuzt, d.h. genau im Nulldurchgang N des Signals D, kippt der Komparator I8 zurück und liefert damit das zeitsignifikante Signal (Pfeil P).

Eine leicht vereinfachte Schaltung des Schwellwert-und Nulldurchgangsdetektors I2 ist in Fig. 7 dargestellt. Der Komparator I8 ist ein handelsüblicher Komparator mit symmetrischen Gegentaktausgängen, das Bezugszeichen I9 bezeichnet einen Gleichspannungsverstärker und der Widerstand 2O symbolisiert die Wellenimpedanz der Laufzeitleitung I7 (Fig. 4).

$R_3$, $R_4$ und $R_5$, $R_6$ sind Spannungsteiler, wobei der Spannungsteiler $R_5$, $R_6$ den Spannungsteiler $R_3$, $R_4$ nachbildet. Am Ausgang des Gleichspannungsverstärkers I9 liegt eine Hilfsspannung $U_H$, die sich im Ruhezustand so einstellt, dass gilt:

$$U_2 = O = U_{IN}\,(Ruhe)$$

Im EIN-Zustand bleibt $U_H$ unverändert, und dank den gleichartigen Ausgängen des Komparators I8 und den gleich grossen Widerständen $R_3$, $R_4$; $R_5$, $R_6$ wird $U_{ref}$ (EIN) = O.

Die Schwellspannung $U_T$ beträgt: $U_T = (U_{OL} - U_{OH})$

$$\frac{R_4}{R_3+R_4}$$

Am Punkt Y, vor dem einen Eingang des Gleichspannungsverstärkers I9, kann über einen Widerstand $R_7$ dem Nullpotential eine kleine Gleichspannung zur Offsetkompensation überlagert werden, welche auch in $U_{ref}$ (EIN) eingeht.

Bei dem erfindungsgemässen Entfernungsmessgerät ist die Laufzeitmessung besonders einfach und genau, weil die Laufzeitleitung alleine die Aufgabe der Verzögerung, Inversion und Addition übernimmt, wobei die Anordnung grundsätzlich beliebige Pulsamplituden verarbeitet, da keine nichtlinearen oder gar begrenzenden Schaltungselemente an der Laufzeitmessung beteiligt sind. Ausserdem wird das Rauschverhalten günstig beeinflusst, weil die Frequenzbandbreite nach oben vom Pulsverstärker und nach unten von der Laufzeitleitung begrenzt wird. Weiter ist die Anordnung unempfindlich gegen geräteinterne Störungen, weil die Nullinie des vom Detektor zu verarbeitenden Signals mit dem Schaltungsnullpunkt (Erdpunkte E in den Fig. 4, 5 und 7) zusammenfällt.

Im Pulsverstärker genügt eine unipolare Ausgangsstufe, welche nur in einer Richtung viel Strom liefern kann, um die unipolaren Originalpulse auf die Leitung zu bringen und die invertierten Reflexionen zu absorbieren. Da ein Puls die Laufzeitleitung hin und zurück durchläuft und anschliessend verschwindet, können verfrühte Lichtreflexionen, welche beispielsweise von der optischen Anordnung oder von Rückstreuungen in der Luft (Nebel) herrühren, die Detektion des Pulses nicht verfälschen.

Wegen der letztgenannten Eigenschaften könnte ohne weiteres anstatt des Startsignals vom Taktgeber ein Teil des ausgesandten Lichtimpulses in den Empfangskanal geleitet und als Startsignal verwendet werden, was eine erhöhte Messgenauigkeit ermöglichen würde.

**Ansprüche**

l. Optoelektrisches Entfernungsmessgerät nach dem Prinzip der Laufzeitmessung mit einem eine Laserdiode enthaltenden Sender, mit einem eine Photodiode aufweisenden Empfänger zum Empfang der von einem Zielobjekt reflektierten Lichtimpulse, mit einem Pulsverstärker, mit einem Pulsdetektor zur Bildung der Differenz aus dem einem reflektierten Lichtimpuls entsprechenden Originalpuls und einer verzögerten Kopie davon zum Zweck der Abgabe eines für den Zeitpunkt des Empfangs eines reflektierten Lichtimpulses signifikanten Stopsignals, und mit einer Zeitmessschaltung zur Ermittlung der Zeit zwischen dem Start des ausgesandten Lichtimpulses und dem Stopsignal des Pulsdetektors, dadurch gekennzeichnet, dass ein Pulsverstärker (7) mit reflexfrei angepasster Ausgangsimpedenz ($Z_o$) eine Laufzeitleitung (l7) treibt, an deren kurzgeschlossenem Ende (l6) eine Inversion und Reflexion des Pulses (U) des Pulsverstärkers stattfindet, und dass in einem der Dauer des auszuwertenden Pulses angepassten Abstand (L) vom kurzgeschlossenen Ende der Laufzeitleitung ein Schwellwert-und Nulldurchgangsdetektor (l2) angeordnet ist.

2. Entfernungsmessgerät nach Anspruch l, dadurch gekennzeichnet, dass der Abstand (L) des Schwellwert-und Nulldurchgangsdetektors (l2) vom kurzgeschlossenen Ende (l6) der Laufzeitleitung (l7) so gewählt ist, dass die Verzögerung (T) zwischen dem Originalpuls (U) und dessen invertierter Kopie ($U_K$) etwa der halben Pulsbreite entspricht.

3. Entfernungsmessgerät nach Anspruch 2, dadurch gekennzeichnet, dass der Schwellwert-und Nulldurchgangsdetektor (l2) durch einen Schmitt-Trigger gebildet ist, dessen Komparator (l8) symmetrische Gegentakt-Ausgänge (OUT, $\overline{OUT}$) aufweist.

4. Entfernungsmessgerät nach Anspruch 2, dadurch gekennzeichnet, dass der Zeitpunkt des Starts des ausgesandten Lichtimpulses durch das Startsignal eines geräteinternen Taktgebers (l) an die Laserdiode des Senders (2) bestimmt ist.

5. Entfernungsmessgerät nach Anspruch 2, dadurch gekennzeichnet, dass ein Teil des ausgesandten Lichtimpulses durch den Empfangskanal (6, 7) geleitet und als Startsignal zur Festlegung des Zeitpunkts des Starts des ausgesandten Lichtimpulses verwendet wird.

6. Entfernungsmessgerät nach Anspruch l, dadurch gekennzeichnet, dass die Laufzeitleitung (l7) als eine an ihrem einen Ende kurzgeschlossene Abzweigung an die Verbindungsleitung zwischen Pulsverstärker (7) und Schwellwert-und Nulldurchgangsdetektor (l2) angeschlossen ist.

7. Entfernungsmessgerät nach Anspruch l, dadurch gekennzeichnet, dass die Laufzeitleitung (l7) durch eine Nachbildung aus mehreren elektrischen Verzögerungsgliedern ersetzt ist.

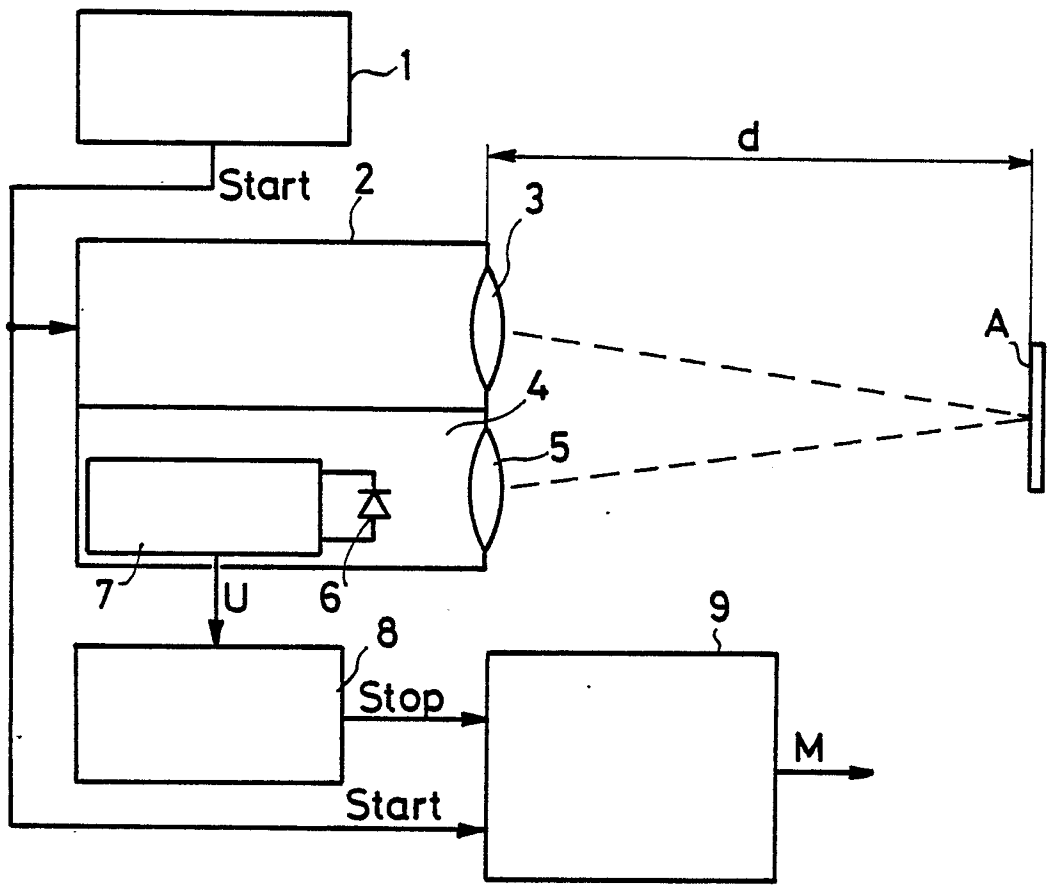


FIG. 1

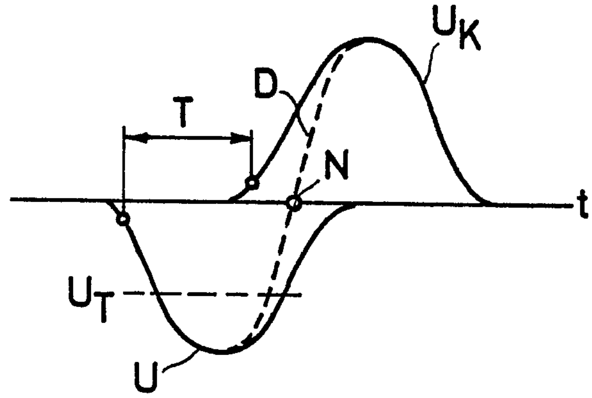


FIG. 2

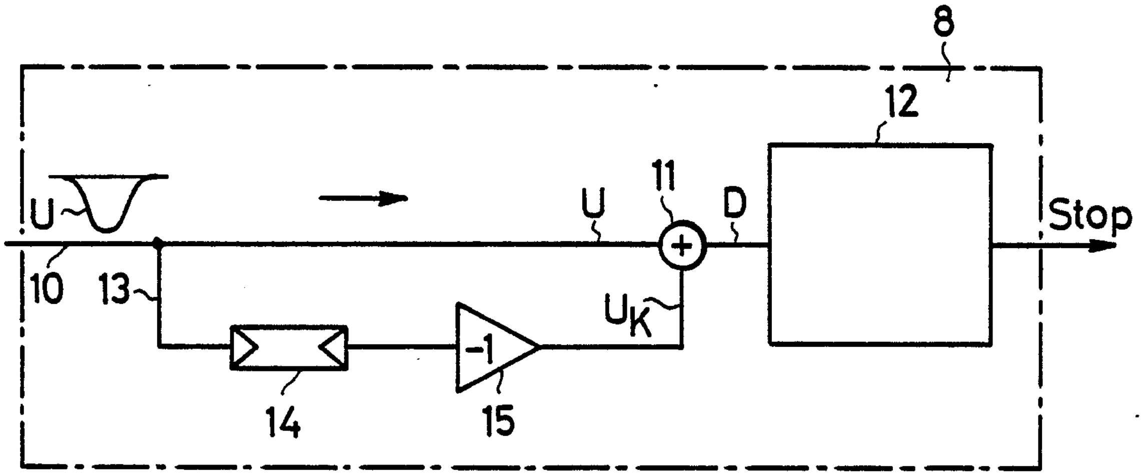


FIG. 3

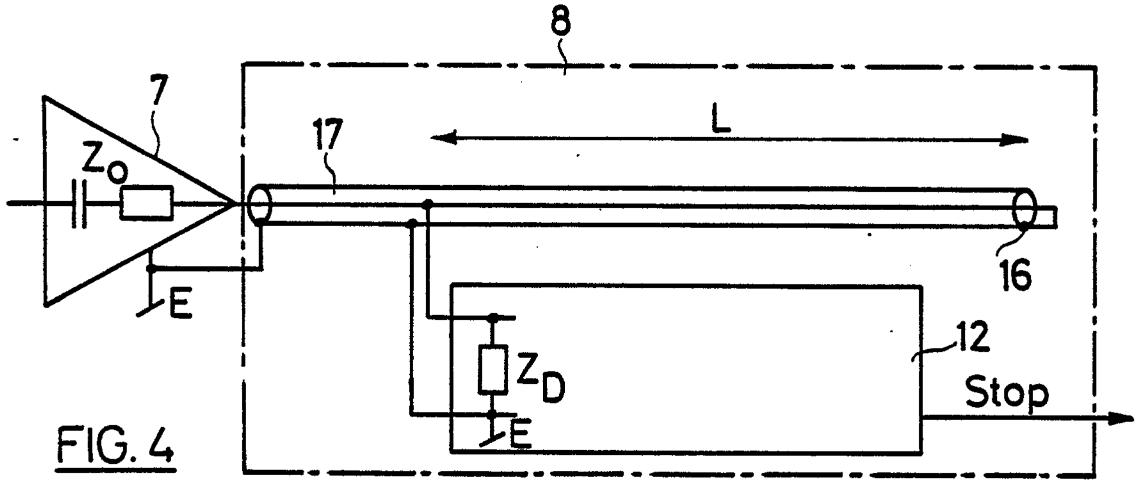


FIG. 4

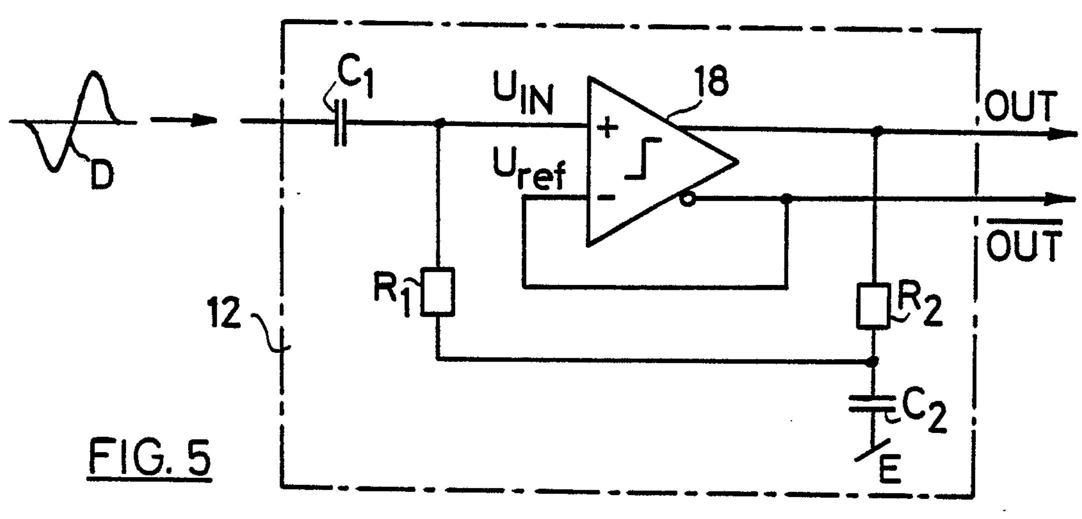


FIG. 5

FIG. 6

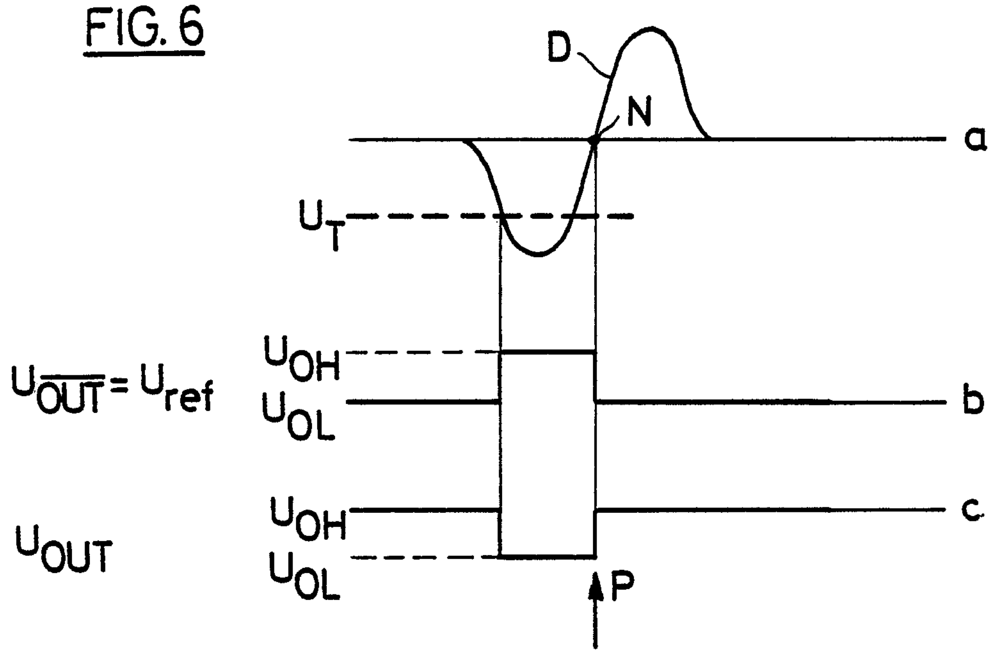
D
N
a
$U_T$
$U_{OH}$
$U_{\overline{OUT}} = U_{ref}$
$U_{OL}$
b
$U_{OH}$
c
$U_{OUT}$
$U_{OL}$
P

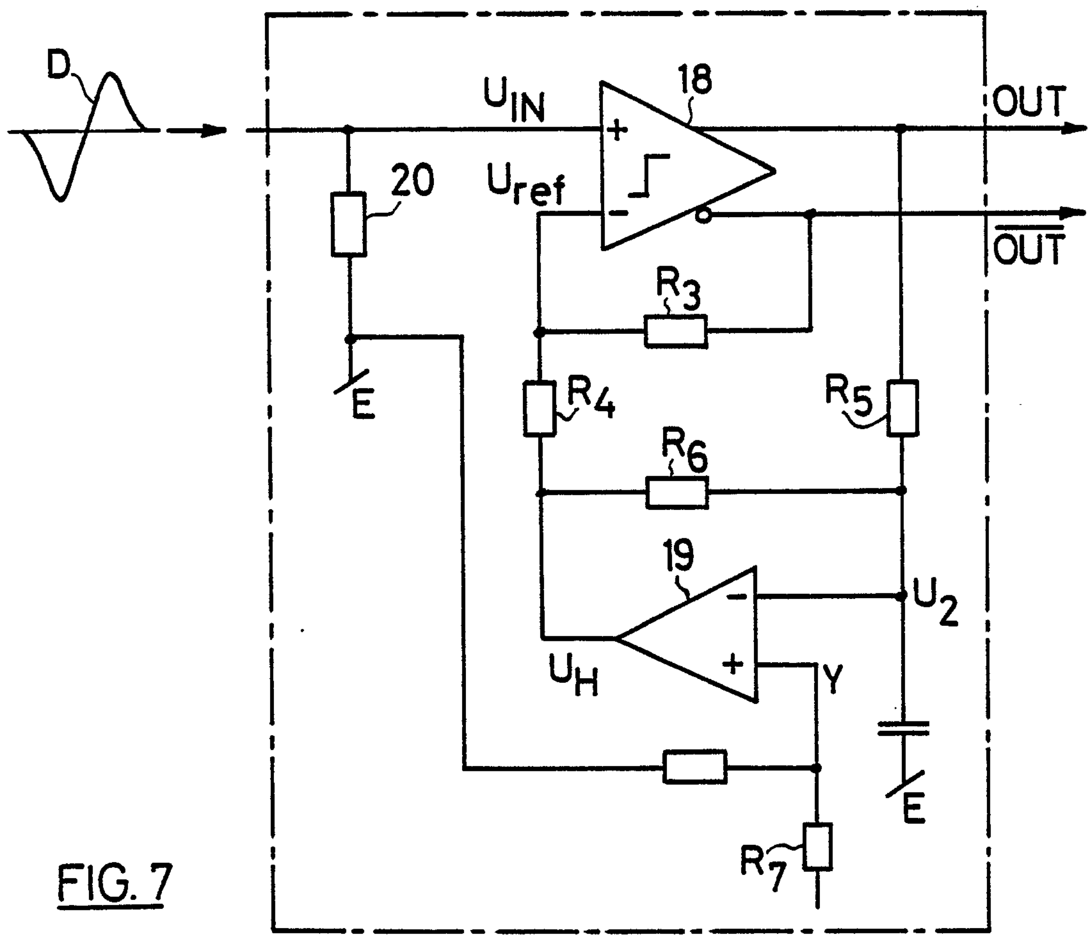
D
$U_{IN}$
18
OUT
20
$U_{ref}$
$\overline{OUT}$
$R_3$
E
$R_4$
$R_5$
$R_6$
19
$U_2$
$U_H$
Y
E
$R_7$

FIG. 7

Europäisches Patentamt

# EUROPÄISCHER RECHERCHENBERICHT

Nummer der Anmeldung

EP 87 11 0449

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EP-A-0 057 447 (MITEC)<br>* Seite 30, Zeile 25 - Seite 36, Zeile 11; Figur 3 * | 1 | G 01 S 17/10<br>G 01 H 3K5/153<br>G 04 F 10/00 |
| A | | 3-5 | |
| | --- | | |
| Y,A | REVIEW OF SCIENTIFIC INSTRUMENTS, Band 45, Nr. 10, Oktober 1974, Seiten 1235-1238, The American Institute of Physics, New York, US; A. BUI et al.: "New simple circuits to eliminate time slewing"<br>* Figur 12 * | 1 | |
| | --- | | |
| A | DE-A-3 347 420 (NUKEM)<br>* Figuren * | 1,2,4,5 | RECHERCHIERTE SACHGEBIETE (Int. Cl.4) |
| | --- | | G 01 S<br>H 03 K<br>G 04 F |
| D,A | WO-A-8 505 456 (SCHWARTE)<br>* Insgesamt * | 1-3 | |
| | --- | | |
| D,A | DE-A-2 634 627 (MITEC)<br>* Insgesamt * | 1,4,5,7 | |
| | --- -/- | | |

Der vorliegende Recherchenbericht wurde für alle Patentansprüche erstellt.

| Recherchenort | Abschlußdatum der Recherche | Prüfer |
|---|---|---|
| DEN HAAG | 22-10-1987 | DEVINE J.J |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

Europäisches Patentamt

**EUROPÄISCHER RECHERCHENBERICHT**

Nummer der Anmeldung

EP 87 11 0449

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | ZEITSCHRIFT FÜR ANGEWANDTE MATHEMATIK UND PHYSIK, Band 20, Nr. 1, 25. Januar 1969, Seiten 113-118, Basel, CH; E. GRAF: "Electronique associée à une mesure triparamétrique en physique nucléaire" * Seite 117, Figur 8 * --- | | |
| A | UND-ODER-NOR + STEUERUNGSTECHNIK, Nr. 10, 1982, Seiten 257-259, Mainz, DE; W. MEHNERT: "Hochgenauer Laserpuls-Entfernungsmesser mit SDS-Relais" * Insgesamt * --- | 1 | |
| A | EP-A-0 076 232 (KERN) ----- | | |

RECHERCHIERTE SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| DEN HAAG | 22-10-1987 | DEVINE J.J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82